# EUROPEAN PATENT APPLICATION

(11) **EP 1 970 957 A2**
(43) Date of publication of application: **17.09.2008**
(21) Application number: 08002502.6
(22) Date of filing: 12.02.2008
(51) Int. Cl.: H01L 27/12, H01L 21/77

(54) **Thin film transistor, an organic light emitting device including the same, and a manufacturing method thereof**

(30) Priority: 21.02.2007 KR 20070017402
(71) Applicant: Samsung Electronics Co., Ltd., Yeongtong-gu Suwon-city, Gyeonggi-do 442-742 (KR)
(72) Inventor: Cho, Kyu-Sik, Yeongton-gu,Suwon-si Gyeonggi-do (KR); Choi, Joon-Hoo, Seoul (KR)
(74) Representative: Dr. Weitzel & Partner

(57) **Abstract**

A thin film transistor includes first and second ohmic contacts formed on a substrate, wherein each of the first and second ohmic contacts includes polycrystalline silicon; a semiconductor formed on the first and second ohmic contacts and the substrate, the semiconductor including microcrystalline silicon; a blocking member formed on the semiconductor; an input electrode formed on the first ohmic contact; an output electrode formed on the second ohmic contact; an insulating layer formed on the blocking member, the input electrode, and the output electrode; and a control electrode formed on the insulating layer and disposed on the semiconductor.

## Description

### CROSS-REFERENCE TO RELATED APPLICATION

This application claims priority to Korean Patent Application No. 10-2007-0017402 filed in the Korean Intellectual Property Office on February 21, 2007, the disclosure of which is incorporated by reference herein in its entirety.

### BACKGROUND OF THE INVENTION

### Technical Field

The present invention relates to a thin film transistor, an organic light emitting device including the same, and a manufacturing method thereof.

### Discussion of the Related Art

Flat panel displays are used in electronic devices such as televisions and laptop computers due to their light weight and thin characteristics.

Different types of flat panel displays exist such as a liquid crystal display (LCD), field emission display (FED), organic light emitting device (OLED), plasma display panel (PDP), and so on.

Among the flat panel displays, the OLED is promising because of its low power consumption, fast response time, and wide viewing angle.

An OLED is a self-emissive display device that displays images by electrically exciting a light emitting organic material.

Generally, an OLED may include a plurality of pixels for displaying images by controlling the brightness of the pixels based on predetermined display information.

Each pixel in the OLED includes an organic light emitting element, a driving transistor for driving the organic light emitting element, and a switching transistor for transmitting a data voltage to the driving transistor. The driving transistor and the switching transistor are thin film transistors. The thin film transistors may be classified as polycrystalline silicon thin film transistors or amorphous silicon thin film transistors depending on the material used to form the transistor's active layer.

Amorphous silicon thin film transistors are used in displays utilizing glass having a low melting point, since an amorphous silicon film can be fabricated at a low temperature. However, the amorphous silicon film has a low carrier mobility, so it may not be well suited for application to a high quality driving circuit of a display panel. In addition, a threshold voltage of the amorphous silicon thin film transistor can easily change over time.

Since polycrystalline silicon has good electric field effect mobility and is capable of high frequency operation, high quality driving circuits use polycrystalline silicon thin film transistors. However, because the polycrystalline silicon thin film transistor has a large off-current, vertical crosstalk is easily generated.

Generally, when forming the polycrystalline silicon thin film transistor, a polycrystalline silicon layer is disposed at a lowest layer, and an ohmic contact layer and an electrode layer are formed thereon. Thereafter, a gate insulating layer and a gate electrode are sequentially formed.

However, during this process, impurities can penetrate into and damage the surface of the polycrystalline silicon layer. To remove the impurities, the upper portion of the surface of the polycrystalline silicon layer may be etched. However, because the polycrystalline silicon layer must be thick to accommodate the etching, this may cause its surface to become non-uniform after the etching is completed.

Accordingly, there exists a need for preventing impurities from penetrating into a surface of a silicon layer of a thin film transistor.

### SUMMARY OF THE INVENTION

A thin film transistor is provided, which includes first and second ohmic contacts formed on a substrate,; a semiconductor formed on the first and second ohmic contacts and the substrate, the semiconductor including microcrystalline silicon; a blocking member formed on the semiconductor; an input electrode formed on the first ohmic contact; an output electrode formed on the second ohmic contact; an insulating layer formed on the blocking member, the input electrode, and the output electrode; and a control electrode formed on the insulating layer and disposed on the semiconductor.

The first and second ohmic contcts may include polycrystalline silicon.

The blocking member may include silicon nitride or silicon oxide.

The input and output electrodes may have substantially the same planar shapes as the first and second ohmic contacts, respectively.

Portions of the input and output electrodes may be disposed on the blocking member.

The semiconductor may have substantially the same planar shape as the blocking member.

The microcrystalline silicon may have a grain diameter of less than 10⁻⁶m.

An organic light emitting device is provided, which includes first and second ohmic contacts formed on a substrate; a first semiconductor formed on the first and second ohmic contacts and the substrate, the first semiconductor including microcrystalline silicon; a blocking member formed on the first semiconductor; a first input electrode and a first output electrode formed on the first and second ohmic contacts, respectively; a first insulating layer formed on the blocking member, the first input electrode, and the first output electrode; a first control electrode formed on the first insulating layer and disposed on the first semiconductor; a second control electrode formed on the first insulating layer and separated from the first control electrode; a second insulating layer formed on the first and second control electrodes; a second semiconductor formed on the second insulating layer and disposed on the second control electrode; third and fourth ohmic contacts formed on the second semiconductor; a second input electrode and a second output electrode formed on the third and fourth ohmic contacts, respectively; a third insulating layer formed on the second input electrode, the second output electrode, and the second semiconductor; and an organic light emitting element connected to the first output electrode and formed on the third insulating layer.

The first and second ohmic contacts may include polycrystalline silicon.

The blocking member may include silicon nitride or silicon oxide.

The first input and output electrodes may have substantially the same planar shapes as the first and second ohmic contacts, respectively.

Portions of the first input and output electrodes may be disposed on the blocking member.

The second semiconductor may comprise amorphous silicon.

An organic light emitting device is provided, which includes: first, second, third and fourth ohmic contacts formed on a substrate and separated from each other; a first semiconductor formed on the first and second ohmic contacts; a second semiconductor formed on the third and fourth ohmic contacts; a first blocking member formed on the first semiconductor; a second blocking member formed on the second semiconductor; a first input electrode formed on the first ohmic contact and a first output electrode formed on the second ohmic contact; a second input electrode formed on the third ohmic contact and a second output electrode formed on the fourth ohmic contact; an insulating layer formed on the first and second input electrodes and the first and second output electrodes; first and second control electrodes formed the insulating layer and overlapping the first and second semiconductors, respectively.

The first and second blocking members may include silicon nitride or silicon oxide.

The first input electrode, the first output electrode, the second input electrode and the second output electrode may have substantially the same planar shapes as the first, second, third and fourth ohmic contacts, respectively.
a portion of the first input electrode and a portion of the first output electrode may be disposed on the first blocking member, and a portion of the second input electrode and a portion of the second output electrode are disposed on the second blocking member.

A method for manufacturing a thin film transistor is provided, which includes forming first and second ohmic contacts on a substrate,; forming a semiconductor on the first and second ohmic contacts and the substrate, the semiconductor including microcrystalline silicon; forming a blocking member on the semiconductor; forming an input electrode on the first and second ohmic contacts and the blocking member; forming an insulating layer on the input electrode, the output electrode, and the blocking member; and forming a control electrode on the insulating layer and on the semiconductor.

The blocking member may include silicon nitride or silicon oxide.

Forming the semiconductor and the blocking member may include depositing a microcrystalline silicon layer, depositing a blocking layer on the microcrystalline silicon layer, and etching the microcrystalline silicon layer and the blocking layer with a photolithography process.

The microcrystalline silicon layer and the blocking layer may be deposited by using chemical vapor deposition (CVD).

The first and second ohmic contacts and the input and output electrodes may be formed by using the same mask.

Forming the ohmic contacts may include depositing an extrinsic semiconductor layer including amorphous silicon, crystallizing the extrinsic semiconductor layer by performing a thermal treatment, and etching the extrinsic semiconductor layer to form the first and second ohmic contacts.

A method for manufacturing an organic light emitting device is provided, which includes forming a driving transistor, wherein forming the driving transistor comprises: forming first and second ohmic contacts on a substrate, wherein each of the first and second ohmic contacts includes polycrystalline silicon with an impurity; forming a semiconductor on the first and second ohmic contacts and the substrate, the semiconductor including microcrystalline silicon; forming a blocking member on the semiconductor; forming an input electrode on the first ohmic contact and the blocking member; forming an output electrode on the second ohmic contact and the blocking member; forming an insulating layer on the input electrode, the output electrode, and the blocking member; and forming a control electrode on the insulating layer and on the semiconductor; forming a switching thin film transistor; and forming an organic light emitting element connected to the output electrode.

### BRIEF DESCRIPTION OF THE DRAWINGS

The above and other features of the present invention will become more apparent by describing in detail exemplary embodiments thereof with reference to the accompanying drawings, in which:
Fig. 1 is an equivalent circuit diagram of a pixel of an organic light emitting device (OLED) according to an exemplary embodiment of the present invention;
Fig. 2 is a layout view of an OLED according to an exemplary embodiment of the present invention;
Figs. 3 to 5 are cross-sectional views showing various exemplary embodiments of the OLED shown in Fig. 2 taken along line III-III;
Figs. 6, 8,10,12,14,16,18, and 20 are layout views of the OLED shown in Figs. 2 and 3 during steps of a manufacturing method thereof according to an exemplary embodiment of the present invention;
Fig. 7 is a cross-sectional view of the OLED shown in Fig. 6 taken along line VII-VIII;
Fig. 9 is a cross-sectional view of the OLED shown in Fig. 8 taken along line IX-IX;
Fig. 11 is a cross-sectional view of the OLED shown in Fig.10 taken along line XI-XI;
Fig. 13 is a cross-sectional view of the OLED shown in Fig. 12 taken along line XIII-XIII;
Fig. 15 is a cross-sectional view of the OLED shown in Fig. 14 taken along line XV-XV;
Fig. 17 is a cross-sectional view of the OLED shown in Fig. 16 taken along line XVII-XVII;
Fig. 19 is a cross-sectional view of the OLED shown in Fig. 18 taken along line XIX-XIX; and
Fig. 21 is a cross-sectional view of the OLED shown in Fig. 20 taken along line XXI-XXI.

### DETAILED DESCRIPTION OF EXEMPLARY EMBODIMENTS

The present invention will be described more fully hereinafter with reference to the accompanying drawings, in which exemplary embodiments of the invention are shown. The present invention may, however, be embodied in many different forms and should not be construed as limited to the embodiments set forth herein.

It will be understood that when an element such as a layer, film, region, or substrate is referred to as being "on"' another element, it can be directly on the other element or intervening elements may also be present.

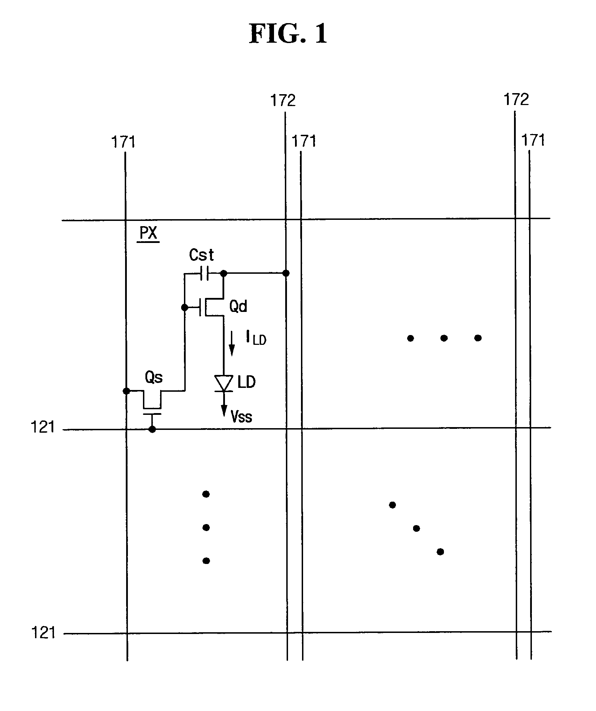

Now, an organic light emitting device (OLED) according to an exemplary embodiment of the present invention will be described in detail with reference to Fig. 1.

Fig. 1 is an equivalent circuit diagram of a pixel of an OLED according to an exemplary embodiment of the present invention.

Referring to Fig. 1, an OLED includes a plurality of signal lines 121, 171, and 172, and a plurality of pixels PX connected thereto and arranged substantially in a matrix.

The signal lines include a plurality of gate lines 121 for transmitting gate signals (or scanning signals), a plurality of data lines 171 for transmitting data signals, and a plurality of driving voltage lines 172 for transmitting a driving voltage. The gate lines 121 extend substantially in a row direction and are substantially parallel to each other, while the data lines 171 and the driving voltage lines 172 extend substantially in a column direction and are substantially parallel to each other.

Each pixel PX includes a switching transistor Qs, a driving transistor Qd, a capacitor Cst, and an organic light emitting diode LD.

The switching transistor Qs has a control terminal connected to one of the gate lines 121, an input terminal connected to one of the data lines 171, and an output terminal connected to the driving transistor Qd. The switching transistor Qs transmits the data signals applied to the data line 171 to the driving transistor Qd in response to a gate signal applied to the gate line 121.

The driving transistor Qd has a control terminal connected to the switching transistor Qs, an input terminal connected to the driving voltage line 172, and an output terminal connected to the organic light emitting diode LD. The driving transistor Qd drives an output current I_{LD} having a magnitude depending on the voltage between the control terminal and the output terminal thereof.

The capacitor Cst is connected between the control terminal and the input terminal of the driving transistor Qd. The capacitor Cst stores a data signal applied to the control terminal of the driving transistor Qd and maintains the data signal after the switching transistor Qs turns off.

The organic light emitting diode LD has an anode connected to the output terminal of the driving transistor Qd and a cathode connected to a common voltage Vss. The organic light emitting diode LD emits light having an intensity depending on the output current I_{LD} of the driving transistor Qd, thereby displaying images.

The switching transistor Qs and the driving transistor Qd are n-channel field effect transistors (FETs). However, at least one of the switching transistor Qs and the driving transistor Qd may be a p-channel FET. In addition, the connections among the transistors Qs and Qd, the capacitor Cst, and the organic light emitting diode LD may be modified.

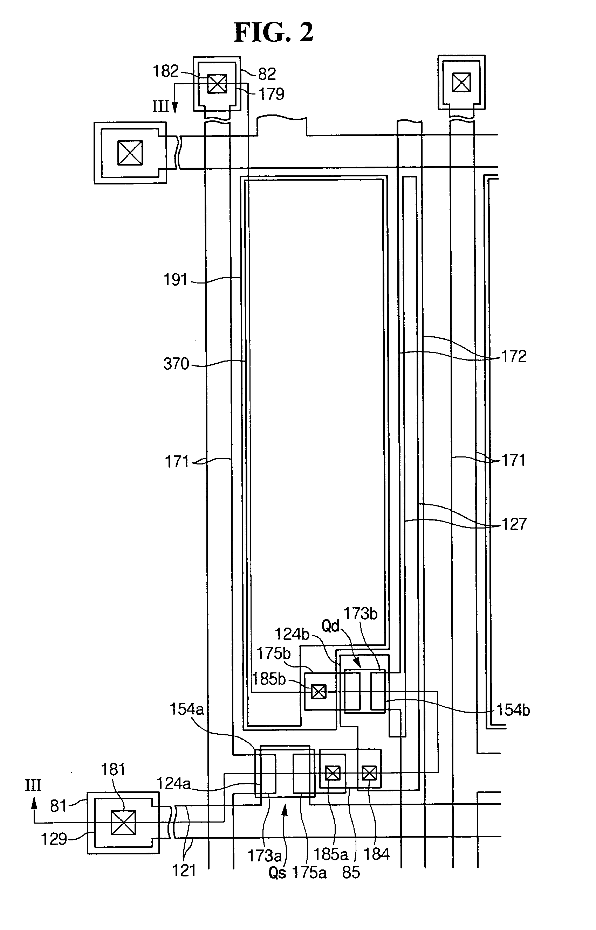

Referring to Figs. 2 to 5, a more detailed structure of the OLED shown in Fig. 1 will now be described.

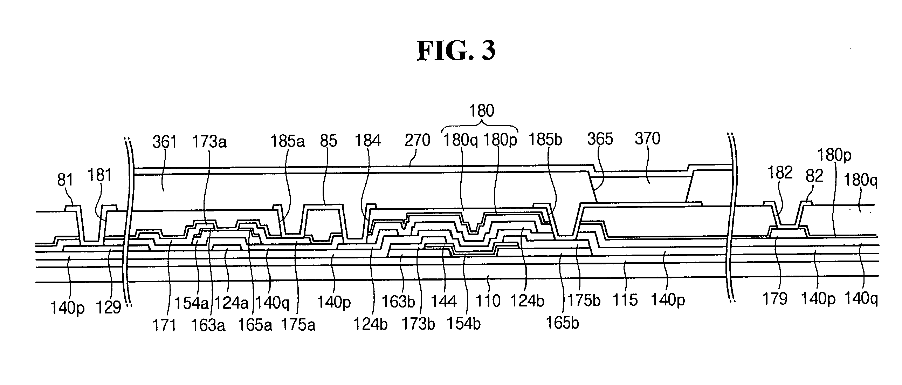

Fig. 2 is a layout view of an OLED according to an exemplary embodiment of the present invention, and Figs. 3 to 5 are cross-sectional views showing various exemplary embodiments of the OLED shown in Fig. 2 taken along line III-III.

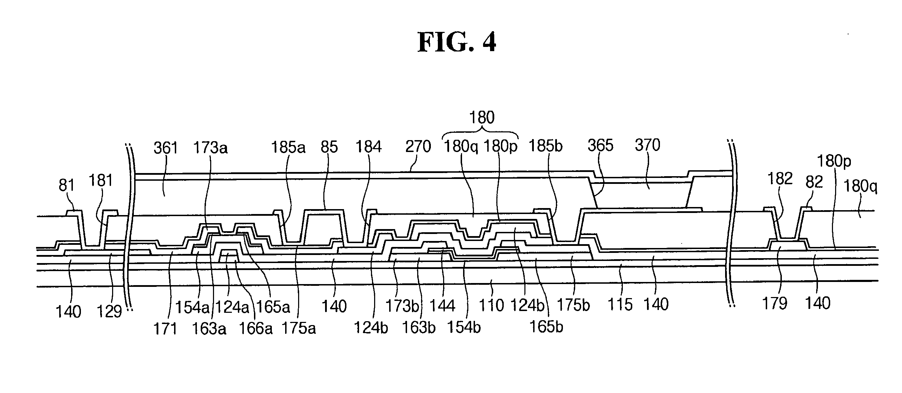

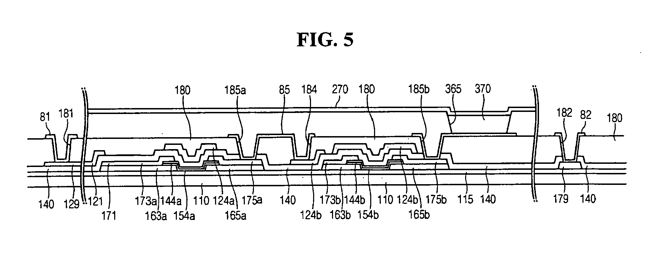

Most of the cross-sectional structure of the OLED will be described with reference to Fig. 3, and differences between the cross-sectional structures will be described with reference to Figs. 4 and 5.

A buffer layer 115 preferably made of silicon oxide (SiO₂) or silicon nitride (SiNₓ) is formed on an insulating substrate 110 made of a material such as transparent glass, quartz, or sapphire.

A plurality of ohmic contact stripes 162 including a plurality of projections 163b and a plurality of ohmic contact islands 165b are formed on the buffer layer 115. The ohmic contacts 163b and 165b are preferably made of silicide or n+ hydrogenated a-Si heavily doped with an n-type impurity such as phosphorous. The ohmic contact stripes 162 are extended in the vertical direction, and the ohmic contact islands 165b and projections 163b face each other in pairs.

A plurality of first semiconductor islands 154b are formed on the ohmic contact islands 165b and projections 163b, and the buffer layer 115 therebetween.

The first semiconductor islands 154b may be microcrystalline silicon and only cover portions of the ohmic contact islands 165b and projections 163b.

A plurality of blocking members 144 are formed on the first semiconductor islands 154b. The blocking members 144 cover the upper surfaces of the first semiconductor islands 154b and may have substantially the same planar shapes as the first semiconductor islands 154b. The blocking members 144 are preferably made of silicon oxide (SiO₂) or silicon nitride (SiNₓ).

A plurality of driving voltage lines 172 and a plurality of first output electrodes 175b are formed on the blocking member 144 and the ohmic contact islands 165b and stripes 162.

The driving voltage lines 172 for transmitting driving voltages extend substantially in the longitudinal direction and have substantially the same planar shapes as the ohmic contact stripes 162. Each driving voltage line 172 includes a plurality of first input electrodes 173b disposed on the projection 163b.

The first output electrodes 175b are separated from the driving voltage lines 172 and have substantially the same planar shapes as the ohmic contact islands 165b.

The first input electrodes 173b contact the projections 163b of the ohmic contact stripes 162, and the first output electrodes 175b contact the ohmic contact islands 165b.

The driving voltage lines 172 and the first output electrodes 175b are preferably made of a refractory metal such as Mo, Cr, Ta, Ti, or alloys thereof. They may have a multi-layered structure preferably including a refractory metal film and a low resistivity film. Good examples of the multi-layered structure are a double-layered structure including a lower Cr film and an upper Al (alloy) film, a double-layered structure of a lower Mo (alloy) film and an upper A1 (alloy) film, and a triple-layered structure of a lower Mo (alloy) film, an intermediate Al (alloy) film, and an upper Mo (alloy) film. However, the driving voltage lines 172 and the first output electrodes 175b may be made of various other metals or conductors.

The driving voltage lines 172 and the first output electrodes 175b have inclined edge profiles, and the inclination angles thereof range from about 30 to about 80 degrees.

A first gate insulating layer 140p preferably made of silicon nitride (SiNx) or silicon oxide (SiOₓ) is formed on the driving voltage lines 172 and the first output electrodes 175b.

A plurality of gate lines 121 and a plurality of first control electrodes 124b are formed on the first gate insulating substrate 140p.

The first control electrodes 124b are disposed on the first semiconductor islands 154b, and include a plurality of storage electrodes 127 to form a storage capacitor Cst by overlapping the driving voltage lines 172.

The gate lines 121 for transmitting gate signals extend substantially in a transverse direction and intersect the driving voltage lines 172. Each gate line 121 further includes an end portion 129 having a large area for contact with another layer or an external driving circuit, and second control electrodes 124a project upward from the gate line 121. The gate lines 121 may extend to be directly connected to a gate driving circuit (not shown) for generating the gate signals, which may be integrated on the substrate 110.

The plurality of gate lines 121 and the plurality of first control electrodes 124b are preferably made of an Al-containing metal such as Al and an Al alloy, a Ag-containing metal such as Ag and a Ag alloy, a Cu-containing metal such as Cu and Cu alloy, a Mo-containing metal such as Mo and a Mo alloy, Cr, Ta, Ti, etc. The plurality of gate lines 121 and the plurality of first control electrodes 124b may have a multi-layered structure including two films having different physical characteristics. One of the two films is preferably made of a low resistivity metal such as an Al-containing metal, an Ag-containing metal, and a Cu-containing metal for reducing signal delay or voltage drop. The other film is preferably made of a material such as a Mo-containing metal, Cr, Ta, and Ti, which has good physical, chemical, and electrical contact characteristics with other materials such as indium tin oxide (ITO) and indium zinc oxide (IZO). Good examples of the combination are a lower Cr film and an upper Al (alloy) film, and a lower Al (alloy) film and an upper Mo (alloy) film. However, the plurality of gate lines 121 and the plurality of first control electrodes 124b may be made of various other metals or conductors.

The lateral sides of the gate lines 121 and the first control electrodes 124b are inclined relative to a surface of the substrate 110, and the inclination angle thereof ranges from about 30 to about 80 degrees.

A second gate insulating layer 140q preferably made of silicon nitride (SiNx) or silicon oxide (SiOx) is formed on the gate lines 121 and the first control electrodes 124b.

A plurality of second semiconductor islands 154a preferably made of hydrogenated amorphous silicon (a-Si) are formed on the second gate insulating layer 140q. The second semiconductor islands 154a are disposed on the second control electrodes 124a.

A plurality of pairs of ohmic contacts 163a and 165a are formed on the second semiconductor islands 154a. The ohmic contacts 163a and 165a are preferably made of silicide or n+ hydrogenated a-Si heavily doped with an n-type impurity such as phosphorous.

A plurality of data lines 171 and a plurality of second output electrodes 175a are formed on the ohmic contacts 163a and 165a and the second gate insulating layer 140q.

The data lines 171 for transmitting data signals extend substantially in the longitudinal direction and intersect the gate lines 121. Each data line 171 includes a plurality of second input electrodes 173a extending toward the second control electrodes 124a and an end portion 179 having a large area for contact with another layer or an external driving circuit. The data lines 171 may extend to be directly connected to a data driving circuit (not shown) for generating the data signals, which may be integrated on the substrate 110.

The second output electrodes 175a are separated from each other and from the data lines 171. Each of a pair of a second input electrode 173a and a second output electrode 175a is disposed opposite each other with respect to the second control electrode 124a.

The data lines 171 and the second output electrodes 175a are preferably made of the same material as that of the driving voltage lines 172.

The data lines 171 and the second output electrodes 175a have inclined edge profiles, and the inclination angles thereof range from about 30 to about 80 degrees.

The ohmic contacts 163a and 165a are interposed only between the underlying second semiconductor members 154a and the overlying data lines 171 and the second output electrodes 175b, and reduce the contact resistance therebetween. The second semiconductor islands 154a include a plurality of exposed portions, which are not covered with the second input and second output electrodes 173a and 175a, such as portions disposed between the second input electrodes 173a and the second output electrodes 175a.

A passivation layer 180 is formed on the data lines 171, the second output electrodes 175a, and the exposed portions of the second semiconductor islands 154a. The passivation layer 180 is preferably made of an inorganic or organic insulator, and it may have a flat top surface. Examples of the inorganic insulator include silicon nitride and silicon oxide. The organic insulator may have photosensitivity and a low dielectric constant. The passivation layer 180 may be made as a single-layered structure of an inorganic insulator or an organic insulator.

The passivation layer 180 has a plurality of contact holes 182 and 185a exposing the end portions 179 of the data lines 171, and the second output electrodes 175a, respectively, and the passivation layer 180 and the second gate insulating layer 140q have a plurality of contact holes 181 and 184 exposing the end portions 129 of the gate lines 121 and the first control electrodes 124b, respectively. In addition, the passivation layer 180 and the first and second gate insulating layers 140p and 140q have a plurality of contact holes 185b exposing the first output electrodes 175b.

A plurality of pixel electrodes 191, a plurality of connecting members 85, and a plurality of contact assistants 81 and 82 are formed on the passivation layer 180, and they are preferably made of a transparent conductor such as ITO or IZO, or a reflective conductor such as Al, Ag, or alloys thereof.

The pixel electrodes 191 are connected to the first output electrodes 175b through the contact holes 185b. The connecting members 85 are connected to the first control electrodes 124b and the second output electrodes 175a through the contact holes 184 and 185a, respectively.

The contact assistants 81 and 82 are connected to the end portions 129 of the gate lines 121 and the end portions 179 of the data lines 171 through the contact holes 181 and 182, respectively, and they protect the end portions 129 and 179 and enhance the adhesion between the end portions 129 and 179 and external devices.

A partition 361 is formed on the passivation layer 180. The partition 361 surrounds the pixel electrodes 191 like a bank to define openings 365, and it is preferably made of an organic or inorganic insulating material. The partition 361 may be made of a photosensitive material containing a black pigment so that the black partition 361 may serve as a light blocking member and the formation of the partition 361 may be simplified.

A plurality of light emitting members 370 are formed on the pixel electrodes 191 and are confined in the openings 365 defined by the partition 361. Each of the light emitting members 370 is preferably made of an organic material that uniquely emits light of one of the primary colors such as red, green, and blue. The OLED displays images by spatially adding the monochromatic primary color light emitted from the light emitting members 370. Hereinafter, pixels representing red, green, and blue color light are referred to as red, green, and blue pixels and are denoted by R, G, and B.

Each of the light emitting members 370 may have a multi-layered structure including an emitting layer (not shown) for emitting light and auxiliary layers (not shown) for improving the efficiency of light emission of the emitting layer. The auxiliary layers may include an electron transport layer (riot shown) and a hole transport layer (not shown) for improving the balance of the electrons and holes, and an electron injecting layer (not shown) and a hole injecting layer (not shown) for improving the injection of the electrons and holes.

A common electrode 270 is formed on the light emitting members 370 and the partition 361. The common electrode 270 is supplied with the common voltage Vss and is preferably made of a reflective metal such as Ca, Ba, Mg, Al, Ag, etc., or a transparent material such as ITO and IZO.

A pixel electrode 191, a light emitting member 370, and the common electrode 270 form an organic light emitting diode LD having the pixel electrode 191 as an anode and the common electrode 270 as a cathode, or vice versa.

In the above-described OLED, a second control electrode 124a connected to a gate line 121, a second input electrode 173a connected to a data line 171, and a second output electrode 175a along with a second semiconductor island 154a form a switching thin film transistor Qs having a channel formed in the second semiconductor island 154a disposed between the second input electrode 173a and the second output electrode 175a. Likewise, a first control electrode 124b connected to a second output electrode 175a, a first input electrode 173b connected to a driving voltage line 172, and a first output electrode 175b connected to a pixel electrode 191 along with a first semiconductor island 154b form a driving thin film transistor Qd having a channel formed in the first semiconductor island 154b disposed between the first input electrode 173b and the first output electrode 175b.

In addition, the first semiconductor islands 154b are made of polycrystalline silicon, and the second semiconductor islands 154a are made of amorphous silicon.

The OLED emits light toward the top or bottom of the substrate 110 to display images. A combination of opaque pixel electrodes 191 and a transparent common electrode 270 is employed in a top emission OLED that emits light toward the top of the substrate 110, and a combination of transparent pixel electrodes 191 and an opaque common electrode 270 is employed in a bottom emission OLED that emits light toward the bottom of the substrate 110.

According to an exemplary embodiment of the present invention, in addition to including one driving transistor Qd and one switching transistor Qs, each pixel PX of an OLED may further include a transistor that compensates for inferiorities of the driving transistor Qd and the organic light emitting diode.

In an exemplary embodiment of the present invention shown in Fig. 4, unlike the embodiment shown in Fig. 3, a second control electrode 124a is disposed on the same layer as a first input electrode 173b and a first output electrode 175b. In addition, the second gate insulating layer 140q is omitted, and a second input electrode 173a and a second output electrode 175a are disposed on the same layer as a first control electrode 124b. Accordingly, the structure of the OLED of Fig. 4 is simplified in comparison with the structure of the OLED of Fig. 3.

In an exemplary embodiment of the present invention shown in Fig. 5, unlike the embodiment shown in Fig. 3, a driving thin film transistor Qd and a switching thin film transistor Qs have substantially the same cross-sectional structures.

In detail, second ohmic contacts 163a and 165a, and first ohmic contacts 163b and 165b are disposed on the same layer as each other, and a second semiconductor island 154a and a second blocking layer 144a are formed on the second ohmic contacts 163a and 165a.

A data line 171 and a second output electrode 175a are disposed on the same layer as a driving voltage line 172 and a first output electrode 175b, and a gate insulating layer 140 covers them.

A gate line 121 is disposed on the gate insulating layer 140, and is covered by a passivation layer 180 of single-layered structure along with a first control electrode 124b.

In the embodiment of Fig. 5, because the switching thin film transistor Qs and the driving thin film transistor Qd are formed on the same layer and with the same structure, the structure and the manufacturing method of the OLED are simplified.

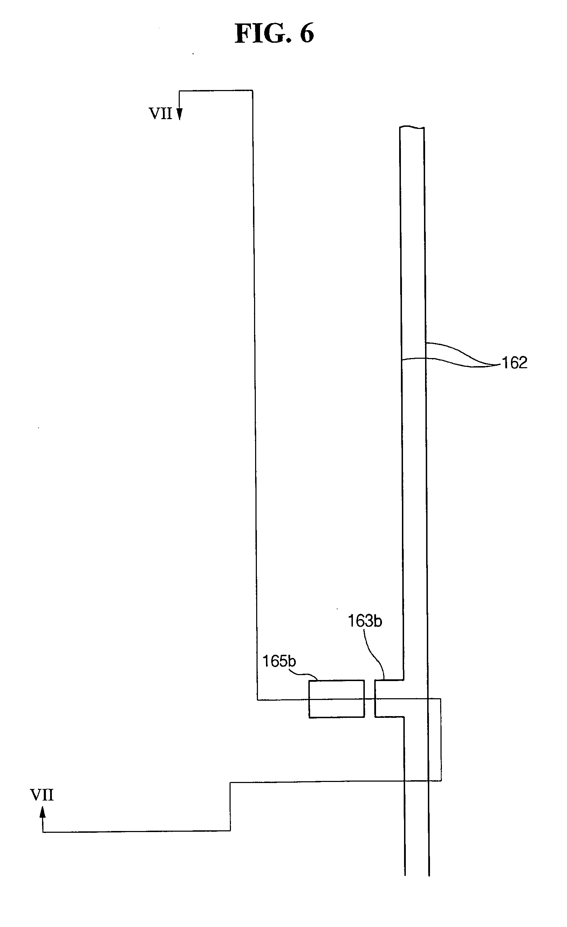

Now, a method of manufacturing the OLED shown in Figs. 2 and 3 is described with reference to Figs. 6 to 21 as well as Figs. 2 and 3.

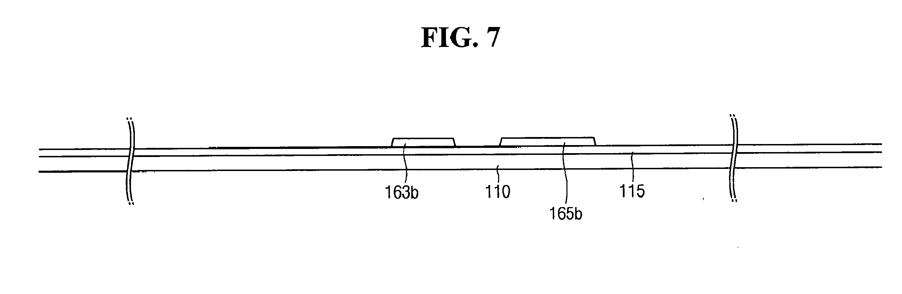

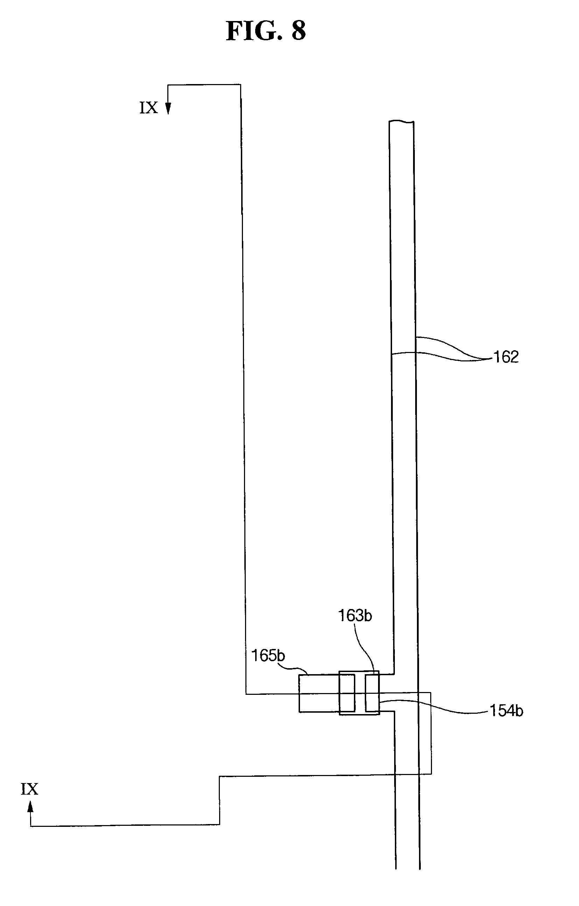

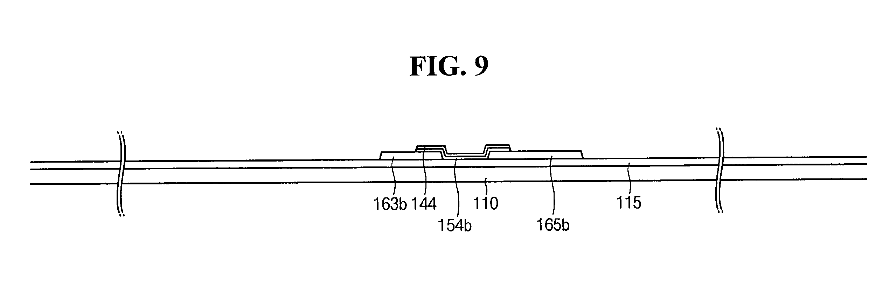

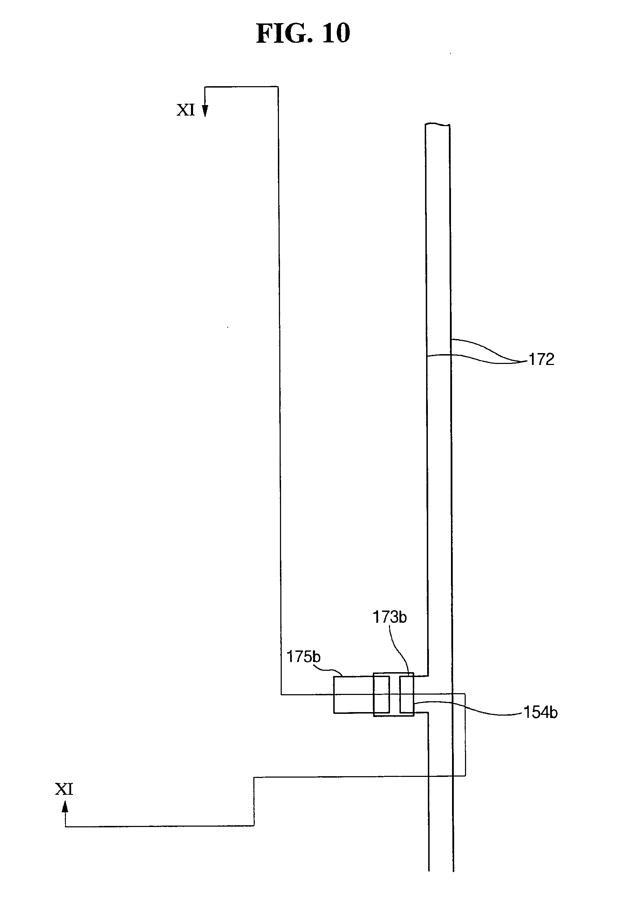

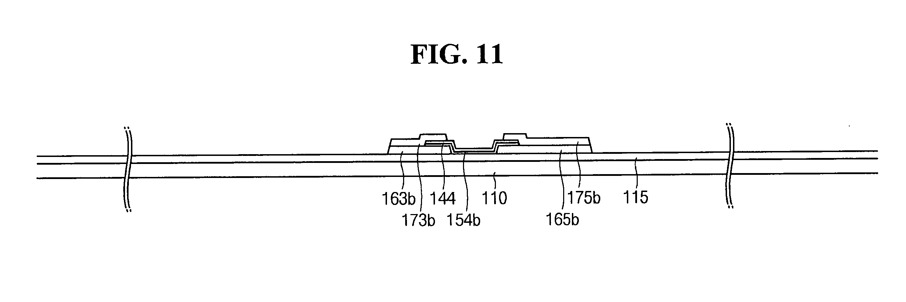

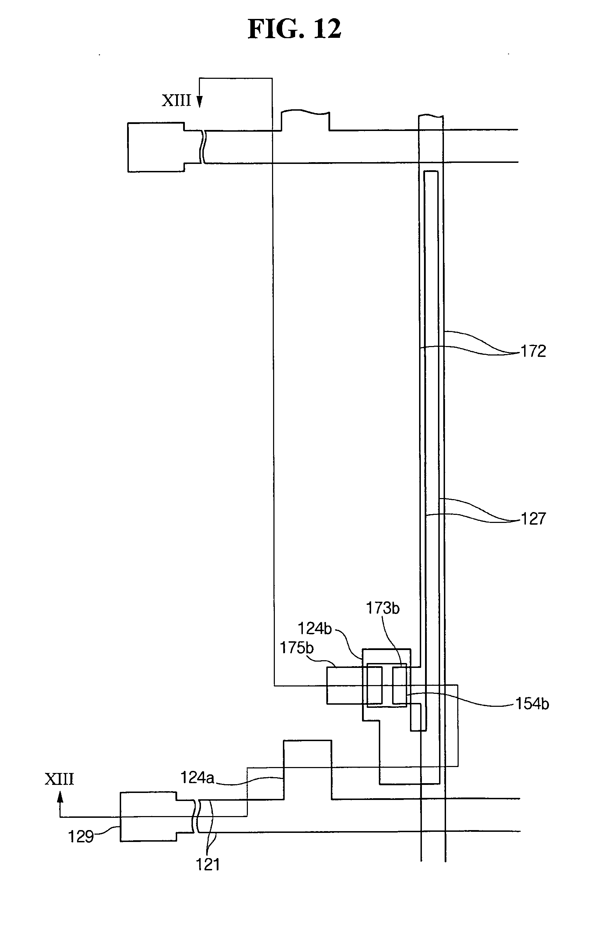

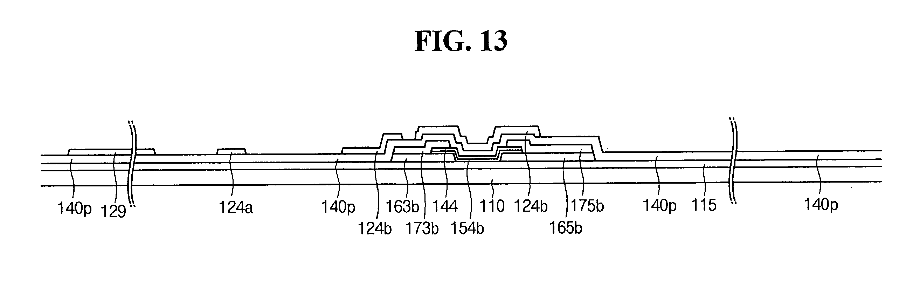

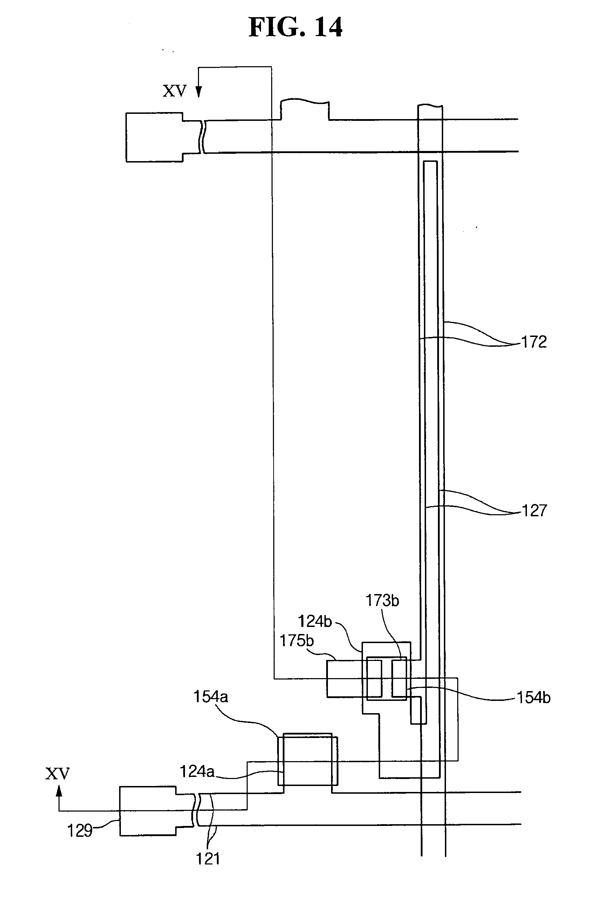

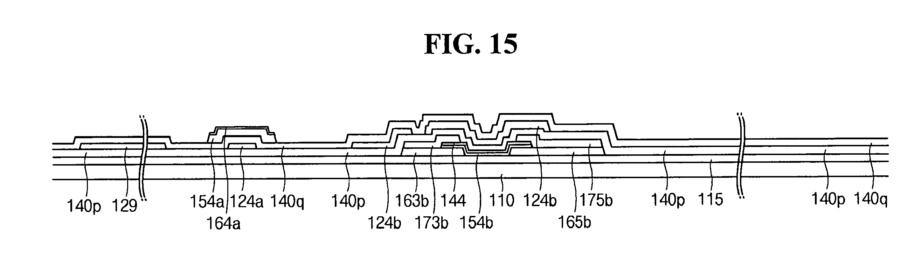

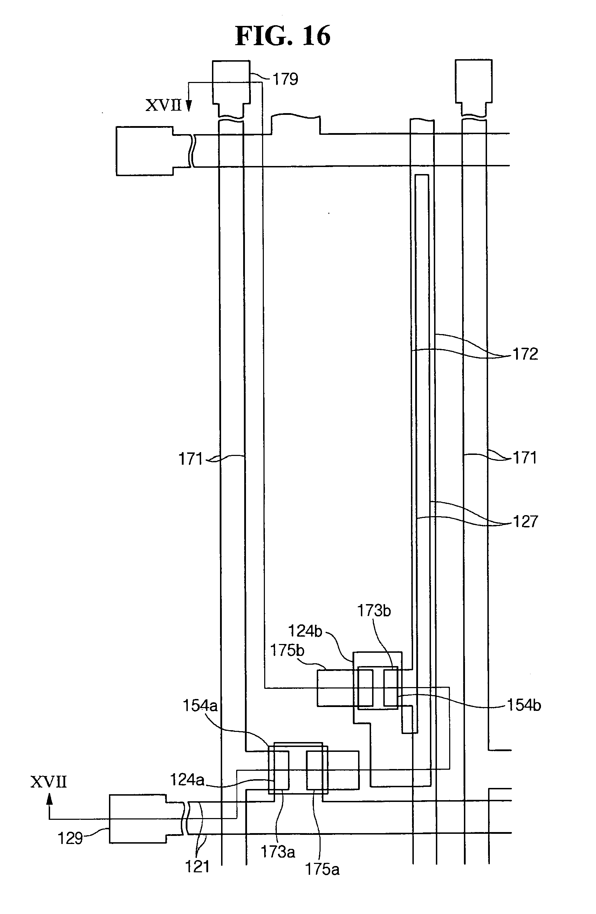

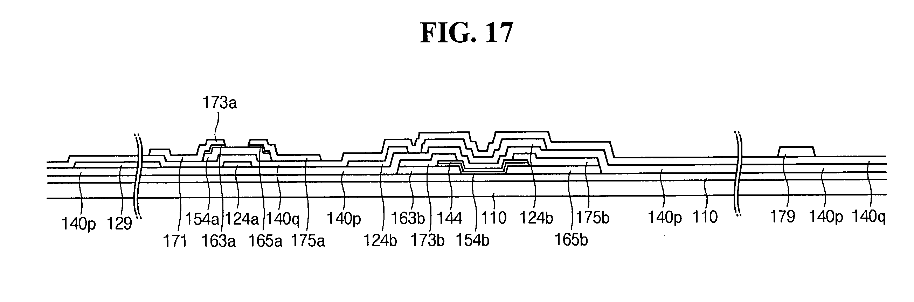

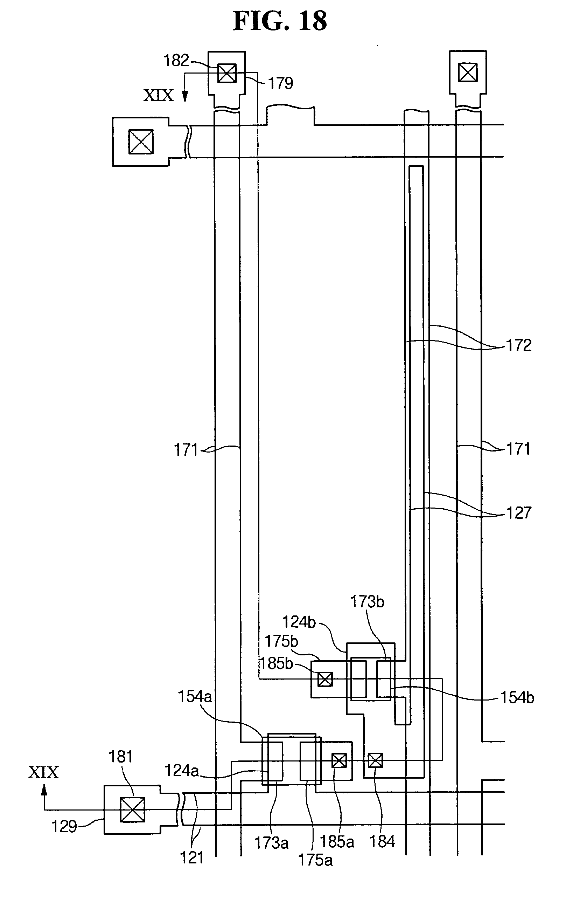

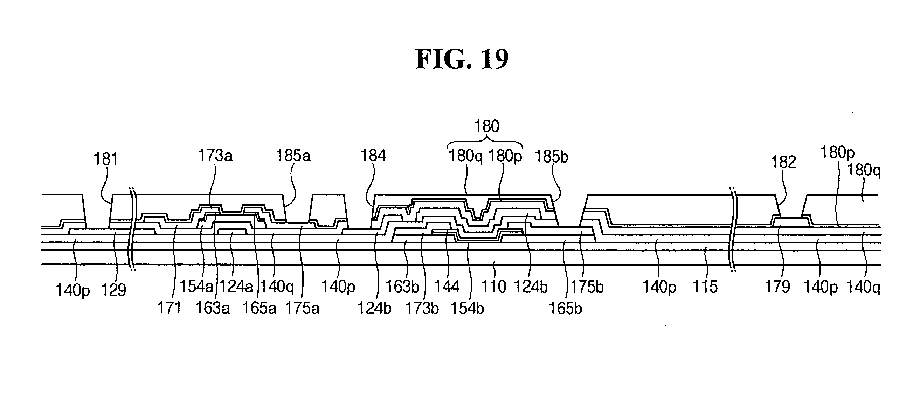

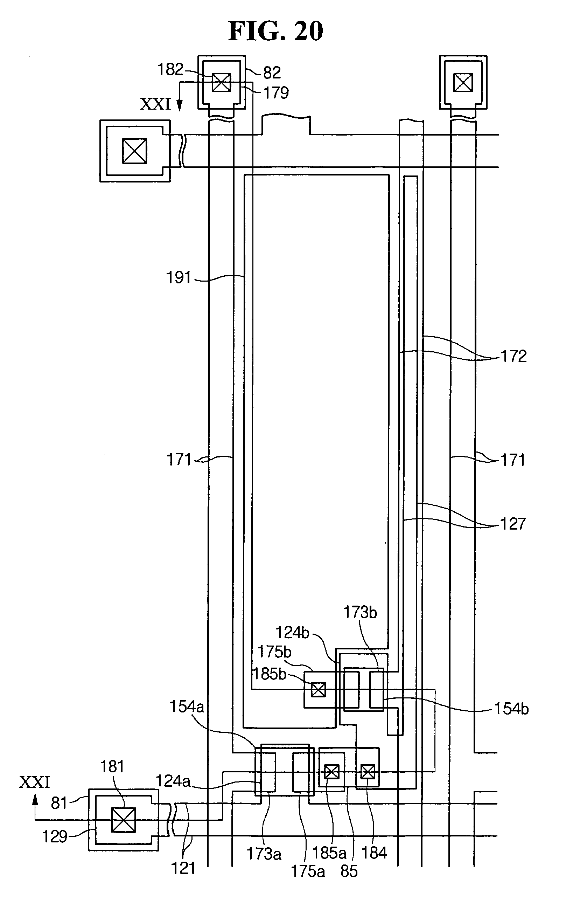

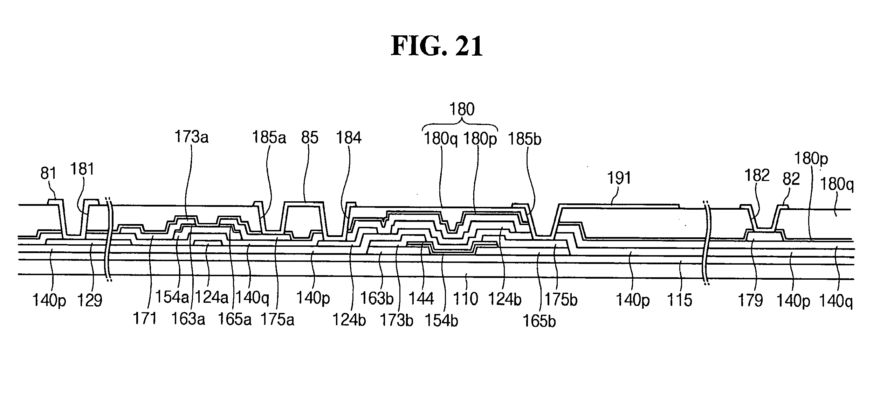

Figs. 6, 8,10,12,14,16,18, and 20 are layout views of the OLED shown in Figs. 2 and 3 during steps of a manufacturing method thereof according to an exemplary embodiment of the present invention, Fig. 7 is a cross-sectional view of the OLED shown in Fig. 6 taken along line VII-VII, Fig. 9 is a cross-sectional view of the OLED shown in Fig. 8 taken along line IX-IX, Fig. 11 is a cross-sectional view of the OLED shown in Fig. 10 taken along line XI-XI, Fig. 13 is a cross-sectional view of the OLED shown in Fig. 12 taken along line XIII-XIII, Fig. 15 is a cross-sectional view of the OLED shown in Fig. 14 taken along line XV-XV, Fig. 17 is a cross-sectional view of the OLED shown in Fig. 16 taken along line XVII-XVII, Fig. 19 is a cross-sectional view of the OLED shown in Fig. 18 taken along line XIX-XIX, and Fig. 21 is a cross-sectional view of the OLED shown in Fig. 20 taken along line XXI-XXI.

Referring to Figs. 6 and 7, a buffer layer 115 and an extrinsic semiconductor layer are sequentially formed on an insulating substrate 110 made of a material such as transparent glass, quartz, or sapphire. The buffer layer 115 is preferably made of silicon oxide (SiO₂) with a thickness of about 5000 □, and the extrinsic semiconductor layer is preferably made of n+ amorphous silicon heavily doped with an n-type impurity with a thickness of about 300 to about 2000 □.

Next, the extrinsic semiconductor layer is crystallized by using a field-enhanced rapid thermal annealing (FE-RTA) method and etched to form a plurality of ohmic contact stripes 162 including a plurality of projections 163b and a plurality of ohmic contact islands 165b.

As shown in Figs. 8 and 9, a microcrystalline silicon layer with a thickness of about 50 to about 2000□ and a blocking layer made of silicon nitride with a thickness of about 500 □ are sequentially deposited by using chemical vapor deposition (CVD). Next, a photoresist film is formed on the blocking layer and exposed. Then, the photoresist film is developed, and the microcrystalline silicon layer and the blocking layer are etched by using the photoresist film as a mask to form a plurality of blocking members 144 and a plurality of first semiconductor islands 154b having substantially the same planar shapes. At this time, the ohmic contact stripes 162 and the ohmic contact islands 165b are exposed.

Here, the term microcrystalline means that the diameter of its grain is less than 10⁻⁶ m, and when the crystal has a grain diameter of more than 10⁻⁶ m, it is classified as polycrystalline.

Because the ohmic contacts 163b and 165b are polycrystalline, the characteristics of the microcrystalline first semiconductor islands 154b, particularly the contact characteristics therebetween, may be improved. Furthermore, because the microcrystalline silicon layer is deposited by using CVD at a low temperature, deformation of the substrate 110 due to thermal treatment and defects of the microcrystalline structure due to dehydrogenation may be prevented. Accordingly, the selection of a material for the blocking members 144 is simplified.

In addition, because the microcrystalline silicon layer is formed after crystallizing the ohmic contacts 163b and 165b, impurities are not diffused into the microcrystalline silicon layer.

On the other hand, when manufacturing a conventional thin film transistor, the surfaces of the first semiconductor islands 154b are exposed when dry-etching the ohmic contacts 163b and 165b, since the ohmic contacts 163b and 165b are disposed on the first semiconductor islands 154b. Thus, the surfaces of the first semiconductor islands 154b may be easily damaged. However, this does not occur in OLEDs according to exemplary embodiments of the present invention, since the blocking members 144 prevent the first semiconductor islands 154b from being damaged during the following processes.

Next, as shown in Figs. 10 and 11, a conductive layer is sputtered or deposited by CVD and photo-etched to form a plurality of driving voltage lines 172 including a plurality of first input electrodes 173b and a plurality of first output electrodes 175b. The mask used in the photolithography process may be the same mask as that used for forming the ohmic contacts 163b and 165b, such that the number of masks may be reduced. In this embodiment, the driving voltage lines 172 have substantially the same planar shapes as the ohmic contact stripes 162, and the first output electrodes 175b have substantially the same planar shapes as the ohmic contact islands 165b.

Referring to Figs. 12 and 13, after deposition of a first gate insulating layer 140p, a plurality of first control electrodes 124b and a plurality of gate lines 121 including a plurality of second control electrodes 124a and a plurality of end portions 129 are formed.

Referring to Figs. 14 and 15, a second gate insulating layer 140q, an intrinsic a-Si layer, and an extrinsic a-Si layer are sequentially deposited by using CVD, and the extrinsic a-Si layer and the intrinsic a-Si layer are photo-etched to form a plurality of extrinsic semiconductor islands 164a and a plurality of second semiconductor islands 154a on the second gate insulating layer 140q.

Next, as shown in Figs. 16 and 17, a conductive layer is sputtered or deposited by CVD and photo-etched to form a plurality of data lines 171 including a plurality of second input electrodes 173a and a plurality of end portions 179, and a plurality of second output electrodes 175a.

The exposed portions of the extrinsic semiconductor islands 164a, which are not covered with the data conductors 171 and 175a, are removed by etching to complete a plurality of ohmic contact islands 163a and 165a and to expose portions of the second semiconductor islands 154a. Oxygen plasma treatment may follow to stabilize the exposed surfaces of the second semiconductor islands 154a.

Referring to Figs. 18 and 19, a passivation layer 180 including a lower layer 180p and an upper layer 180q is deposited by CVD or printing, etc., and patterned along with the first and the second gate insulating layers 140p and 140q to form a plurality of contact holes 181, 182, 184, 185a, and 185b exposing portions of the second output electrodes 175a and the first control electrodes 124b, the first output electrodes 175b, and the end portions 129 and 179 of the gate lines 121 and the data lines 171.

Next, as shown in Figs. 20 and 21, a transparent conductive film is deposited on the passivation layer 180 by sputtering, etc., and it is photo-etched to form a plurality of pixel electrodes 191, a plurality of connecting members 85, and a plurality of contact assistants 81 and 82.

The above-described manufacturing method can be modified to create an OLED having a different structure such as, for example, the OLEDs of Figs. 4 and 5.

In the above-described manufacturing method, the ohmic contacts are first formed and crystallized, and then, the microcrystalline semiconductors are formed such that misalignments due to damaged semiconductors, diffusion of impurities, and substrate deformation may be prevented.

In addition, the insulating layer is formed between the electrodes and the semiconductors such that defects due to contact therebetween may be prevented. In this case, the thermal treatment of the semiconductors may be omitted. Accordingly, the selection of a material for the insulating layer may be simplified.

Further, the driving voltage lines, the output electrodes, and the ohmic contacts are formed by using the same mask such that the manufacturing process may be simplified.

While the present invention has been described in detail with reference to the exemplary embodiments, those skilled in the art will appreciate that various modifications and substitutions can be made thereto without departing from the spirit and scope of the present invention as set forth in the appended claims.

## Claims

1. A thin film transistor, comprising:
first and second ohmic contacts formed on a substrate;
a semiconductor formed on the first and second ohmic contacts and the substrate, the semiconductor including microcrystalline silicon;
a blocking member formed on the semiconductor;
an input electrode formed on the first ohmic contact;
an output electrode formed on the second ohmic contact;
an insulating layer formed on the blocking member, the input electrode, and the output electrode; and
a control electrode formed on the insulating layer and disposed on the semiconductor.

2. The thin film transistor of claim 1, wherein each of the first and second ohmic contacts includes polycrystalline silicon.

3. The thin film transistor of claim 1, wherein the blocking member includes silicon nitride or silicon oxide.

4. The thin film transistor of claim 1, wherein the input and output electrodes have substantially the same planar shape as the first and second ohmic contacts, respectively.

5. The thin film transistor of claim 1, wherein a portion of the input electrode and a portion of the output electrode are disposed on the blocking member.

6. The thin film transistor of claim 1, wherein the semiconductor has substantially the same planar shape as the blocking member.

7. The thin film transistor of claim 1, wherein the microcrystalline silicon has a grain diameter of less than 10⁻⁶ m.

8. An organic light emitting device, comprising:
first and second ohmic contacts formed on a substrate;
a first semiconductor formed on the first and second ohmic contacts and the substrate, the first semiconductor including microcrystalline silicon;
a blocking member formed on the first semiconductor;
a first input electrode formed on the first ohmic contact and a first output electrode formed on the second ohmic contact;
a first insulating layer formed on the blocking member, the first input electrode, and the first output electrode;
a first control electrode formed on the first insulating layer and disposed on the first semiconductor;
a second control electrode formed on the first insulating layer and separated from the first control electrode;
a second insulating layer formed on the first and second control electrodes;
a second semiconductor formed on the second insulating layer and disposed on the second control electrode;
third and fourth ohmic contacts formed on the second semiconductor;
a second input electrode formed on the third ohmic contact and a second output electrode formed on the fourth ohmic contact;
a third insulating layer formed on the second input electrode, the second output electrode, and the second semiconductor; and
an organic light emitting element connected to the first output electrode and formed on the third insulating layer.

9. The device of claim 8, wherein each of the first and second ohmic contacts includes polycrystalline silicon.

10. The device of claim 8, wherein the blocking member includes silicon nitride or silicon oxide.

11. The device of claim 8, wherein the first input and output electrodes have substantially the same planar shapes as the first and second ohmic contacts, respectively.

12. The device of claim 8, wherein a portion of the first input electrode and a portion of the first output electrode are disposed on the blocking member.

13. The device of claim 8, wherein the second semiconductor comprises amorphous silicon.

14. An organic light emitting device, comprising:
first, second, third and fourth ohmic contacts formed on a substrate and separated from each other,
a first semiconductor formed on the first and second ohmic contacts,
a second semiconductor formed on the third and fourth ohmic contacts,
a first blocking member formed on the first semiconductor,
a second blocking member formed on the second semiconductor,
a first input electrode formed on the first ohmic contact and a first output electrode formed on the second ohmic contact;
a second input electrode formed on the third ohmic contact and a second output electrode formed on the fourth ohmic contact,
an insulating layer formed on the first and second input electrodes and the first and second output electrodes,
first and second control electrodes formed the insulating layer and overlapping the first and second semiconductors, respectively.

15. The device of claim 14, wherein the first and second blocking members include silicon nitride or silicon oxide.

16. The device of claim 14, wherein the first input electrode, the first output electrode, the second input electrode and the second output electrode have substantially the same planar shapes as the first, second, third and fourth ohmic contacts, respectively.

17. The device of claim 14, wherein a portion of the first input electrode and a portion of the first output electrode are disposed on the first blocking member, and a portion of the second input electrode and a portion of the second output electrode are disposed on the second blocking member.

18. A method for manufacturing a thin film transistor, comprising:
forming first and second ohmic contacts on a substrate;
forming a semiconductor on the first and second ohmic contacts and the substrate, the semiconductor including microcrystalline silicon;
forming a blocking member on the semiconductor;
forming an input electrode and an output electrode on the first and second ohmic contacts and the blocking member;
forming an insulating layer on the input electrode, the output electrode, and the blocking member; and
forming a control electrode on the insulating layer and on the semiconductor.

19. The method of claim 18, wherein the blocking member includes silicon nitride or silicon oxide.

20. The method of claim 18, wherein forming the semiconductor and the blocking member comprises:
depositing a microcrystalline silicon layer;
depositing a blocking layer on the microcrystalline silicon layer; and
etching the microcrystalline silicon layer and the blocking layer with a photolithography process.

21. The method of claim 20, wherein the microcrystalline silicon layer and the blocking layer are deposited by using chemical vapor deposition (CVD).

22. The method of claim 18, wherein the first and second ohmic contacts and the input and output electrodes are formed by using the same mask.

23. The method of claim 18, wherein forming the first and second ohmic contacts comprises:
depositing an extrinsic semiconductor layer including amorphous silicon;
crystallizing the extrinsic semiconductor layer by performing a thermal treatment; and
etching the extrinsic semiconductor layer to form the first and second ohmic contacts.

24. A method for manufacturing an organic light emitting device, comprising:
forming a driving thin film transistor, wherein forming the driving thin film transistor comprises:
forming first and second ohmic contacts on a substrate;
forming a semiconductor on the first and second ohmic contacts and the substrate, the semiconductor including microcrystalline silicon;
forming a blocking member on the semiconductor;
forming an input electrode and an output electrode on the first and second ohmic contacts and the blocking member;
forming an insulating layer on the input electrode, the output electrode, and the blocking member; and
forming a control electrode on the insulating layer and on the semiconductor;
forming a switching thin film transistor connected to the control electrode; and
forming an organic light emitting element connected to the output electrode.
